(19) Europäisches Patentamt

European Patent Office

Office européen des brevets

(11) Veröffentlichungsnummer: **0 268 796**

**A2**

(12) **EUROPÄISCHE PATENTANMELDUNG**

(21) Anmeldenummer: 87114761.7

(22) Anmeldetag: 09.10.87

(51) Int. Cl.⁴: **G01R 21/133** , G01R 23/15

Die Bezeichnung der Erfindung wurde geändert (Richtlinien für die Prüfung im EPA, A-III, 7.3).

(30) Priorität: 23.10.86 DE 3636114

(43) Veröffentlichungstag der Anmeldung:
01.06.88 Patentblatt 88/22

(84) Benannte Vertragsstaaten:
AT BE CH DE FR GB IT LI NL SE

(71) Anmelder: **Siemens Aktiengesellschaft Berlin und München**
**Wittelsbacherplatz 2**
**D-8000 München 2(DE)**

(72) Erfinder: **Förder, Walter, Dipl.-Phys.**
**Gewendeweg 74**
**D-8510 Fürth(DE)**
Erfinder: **Windsheimer, Klaus, Dipl.-Ing. (FH)**
**Burgambach 34**
**D-8533 Scheinfeld(DE)**
Erfinder: **Steinmüller, Günter, Dipl.-Ing. (FH)**
**Laufamholzstrasse 65**
**D-8500 Nürnberg(DE)**

(54) **Statischer Elektrizitätszähler.**

(57) Bei der erfindungsgemäßen Anordnung werden Strom und Spannung über eine Anpaßstufe (1) einem Multiplizierer (2) zugeführt, dem ein Quantisierer (3) nachgeschaltet ist. Eine elektronische Sperre (6) ist zwischen den Quantisierer (3) und einen Frequenzteiler (4) geschaltet. Dem Quantisierer (3) ist eine Impulsabstandskontrolle (7) nachgeschaltet, die ein Sperrsignal an die Sperre (6) gibt, wenn der zeitliche Abstand zwischen zwei aufeinanderfolgenden Impulsen eine Zeitschwelle überschreitet, während ansonsten die Sperre (6) unwirksam ist. Der Frequenzteiler (4) gibt in Abhängigkeit von den aufsummierten Impulsen ein Signal an die nachgeschaltete Anzeige (5) ab, in der z.B. ein Zählwerk weitergeschaltet wird.

FIG 1

## Statischer Zähler

Die Erfindung betrifft einen statischen Zähler, bestehend aus einer Reihenschaltung einer Anpaßstufe, eines Multiplizierers, eines Quantisierers, einer Sperre, die in Abhängigkeit von der mit dem Quantisierer erfaßten Leistung unterhalb einer Leistungsschwelle die Ausgangsimpulse des Quantisierers sperrt, eines Frequenzteilers und einer Anzeige.

Ein derartiger Aufbau eines Zählers ist beispielsweise bekannt aus der US-PS 3 939 413 und der US-PS 3 875 508.

Ein kWh-Zähler gemäß den oben genannten US-Patentschriften mißt die an einen elektrischen Verbraucher abgegebene Energie. Dabei transformieren Meßwandler die Spannungen und Ströme auf Größen, die von dem nachgeschalteten elektronischen Multiplizierer verarbeitet werden können. Durch Multiplikation der Momentanwerte von Strom und Spannung wird die elektrische Leistung ermittelt. Die Ausgangsspannungen des Multiplizierers werden über einen Tiefpaßfilter einem Quantisierer zugeführt, der diese Ausgangsspannung in eine Impulsfolge mit leistungsproportionaler Frequenz umsetzt. Die leistungsproportionale Impulsfolge wird einem Filter zugeführt, welches ein Sperrsignal an den Eingang eines nachgeschalteten Gatters führt, wenn eine vorbestimmte Impulsfolgefrequenz unterschritten wird. Damit wird die am zweiten Eingang des Gatters anstehende leistungsproportionale Impulsfolge nicht an den Ausgang des Gatters weitergeleitet. Die Überwachung der Impulsfolgefrequenz erfolgt durch Mittelwertbildung und einen Schwellwertschalter. Überschreitet die leistungsproportionale Impulsfolge eine vorgegebene Frequenz, so wird das Gatter "frei" geschaltet, wodurch die leistungsproportionale Impulsfolge über einen nachgeschalteten Frequenzteiler einer Anzeige zugeführt wird.

Nachteil dieser Ausführungsformen ist, daß mehrere Impulse der leistungsproportionalen Impulsfolge zur Bildung des Mittelwertes herangezogen werden müssen, um die Spannungsschwelle am Eingang des Schwellwertschalters überschreiten zu können.

Aufgabe der Erfindung ist es, eine Zählerschaltung so auszuführen, daß die Erfassung einer Leistungsschwelle ohne Mittelwertbildung möglich wird.

Diese Aufgabe wird erfindungsgemäß dadurch gelöst, daß dem Quantisierer eine Impulsabstandskontrolle nachgeschaltet ist, die ein Sperrsignal an die Sperre gibt, wenn der zeitliche Abstand zwischen einem ersten und einem nachfolgenden zweiten Impuls eine Zeitschwelle überschreitet, während ansonsten die Sperre unwirksam ist.

Damit werden - wie beim Ferrariszähler - Leistungen erst ab einem Schwellwert registriert. Die Schaltung reagiert unverzögert auf Leistungsänderungen, da jeder einzelne Impuls bezüglich seines Abstandes zum vorhergehenden überprüft wird. Eine sichere Eliminierung von Störeffekten, insbesondere Einstreuungen von äußeren Magnetfeldern, Kriechströmen und Offsetspannungen, ist damit gewährleistet. Eine Erfassung dieser Störeffekte wäre besonders im Nullast- und Kleinlastbereich sehr störend, weil sie einen tatsächlich nicht vorhandenen Verbrauch vortäuschen könnten.

Vorteilhafterweise ist die Zeitschwelle variabel einstellbar. Damit kann z.B. bei Einsatz in unterschiedlichen Lastbereichen die Leistungsschwelle, ab der der Zähler registriert wird, angepaßt werden.

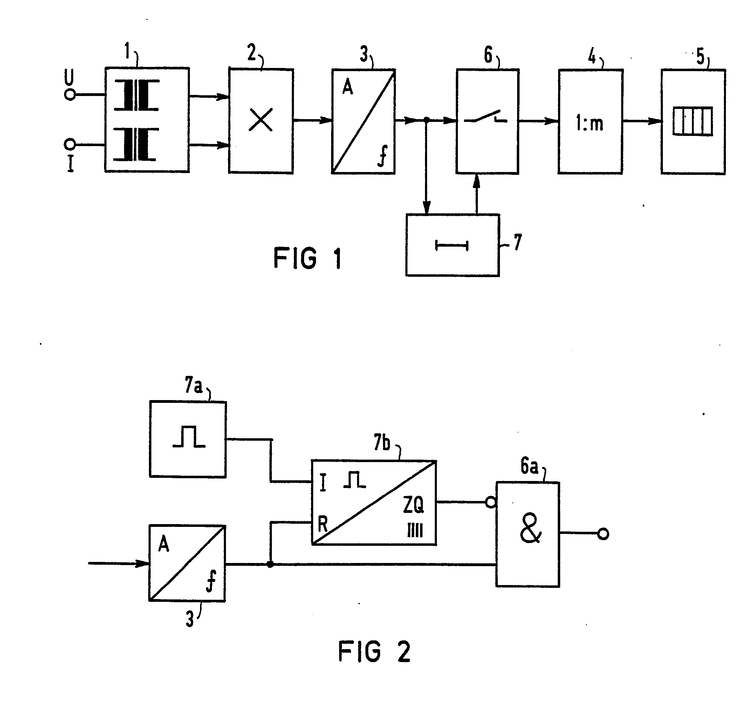

Ein Ausführungsbeispiel der Erfindung wird nachfolgend anhand der FIG 1 und 2 näher erläutert:

FIG 1 zeigt den schematischen Aufbau eines Ausführungsbeispieles für einen Zähler gemäß der Erfindung und

FIG 2 ein Ausführungsbeispiel für eine Impulsabstandskontrolle 7.

Strom und Spannung eines Verbrauchers werden mit einer Anpaßstufe 1, die z.B. aus Meßwandlern bestehen kann, auf eine für einen nachgeschalteten Multiplizierer 2 geeignete Größe transformiert. Die leistungsproportionale Ausgangsspannung des Multiplizierers 2 wird in einem Quantisierer 3 in eine Impulsfolge mit leistungsproportionaler Frequenz umgewandelt. Dem Quantisierer 3 ist eine elektronische Sperre 6 nachgeschaltet. In einer Impulsabstandskontrolle 7 wird das Ausgangssignal des Quantisierers 3 hinsichtlich des Impulsabstandes zwischen zwei aufeinanderfolgenden Impulsen überprüft.

Jeder Impuls startet die Impulsabstandskontrolle 7. Überschreitet der zeitliche Abstand zwischen einem ersten und einem zweiten nachfolgenden Impuls eine vorgegebene Zeitschwelle, so wird ein Sperrsignal erzeugt, welches einen Schalter 6a in der Sperre 6 öffnet, so daß der zweite Impuls nicht zum Frequenzteiler 4 weitergeleitet wird. Durch den zweiten Impuls wird die Impulsabstandskontrolle 7 neu gestartet und das Sperrsignal aufgehoben. Liegt der zeitliche Abstand zwischen dem zweiten und einem nachfolgenden dritten Impuls innerhalb der vorgegebenen Zeitschwelle, so wird dieser über die Sperre 6 dem Frequenzteiler 4 zugeführt und dort aufsummiert. Überschreitet die Anzahl der im Frequenzteiler 4 aufsummierten Impulse einen vorgegebenen Wert, so wird ein Impuls an die Anzeige 5 weitergeleitet, der z.B. ein Zählwerk weiterschaltet. Da der Impulsabstand zwischen zwei Impulsen indirekt proportional der in dieser Zeit verbrauch ten Leistung ist, läßt sich vorteilhafterweise in Abhängigkeit von der Zeitschwelle eine Mindestleistung einstellen, bei der eine Registrierung durch die Anzeige erfolgen soll.

In der FIG 2 wird ein Ausführungsbeispiel der Impulsabstandskontrolle 7 näher erläutert. Dem Zählereingang eines Zählers 7b werden Taktimpulse aus einem Taktgeber 7a und dem Rücksetzeingang des Zählers 7b positive Impulse aus dem Quantisierer 3 zugeführt. Der Ausgang des Zählers 7b ist mit einem invertierenden Eingang eines als Sperre 6 wirkenden UND-Gatters 6a verbunden, an dessen nichtinvertierendem Eingang das Ausgangssignal des Quantisierers 3 ansteht. Jeder Impuls aus dem Taktgeber 7a - schaltet den Zähler 7b um einen Zählschritt weiter. In einem ersten Betriebsfall, d.h. wenn der zeitliche Abstand zwischen zwei aufeinanderfolgenden Impulsen des Quantisierers 3 unter der Zeitschwelle liegt, erreicht der Zähler 7b keinen vorbestimmten Zählwert, weil die abfallende Flanke des zweiten Impulses den Zähler 7b vorher zurücksetzt. Das Ausgangssignal des Zählers 7b bleibt unverändert, der zweite Impuls wird über das UND-Gatter 6a weitergeleitet.

In einem weiteren Betriebsfall, d.h. wenn der zeitliche Abstand zwischen zwei aufeinanderfolgenden Impulsen des Quantisierers 3 über der Zeitschwelle liegt, erreicht der Zähler 7b einen vorbestimmten Zählwert. Das Ausgangssignal des Zählers 7b wird positiv, der zweite Impuls wird durch das UND-Gatter 6a gesperrt. Die abfallende Flanke dieses zweiten Impulses setzt den Zähler 7b zurück, das Ausgangssignal des Zählers 7b ändert den positiven Schaltzustand. Damit wird die Zeitmessung der Impulsabstandskontrolle 7 neu gestartet.

## Ansprüche

1. Statischer Zähler, bestehend aus einer Reihenschaltung einer Anpaßstufe (1), eines Multiplizierers (2), eines Quantisierers (3), einer Sperre (6), die in Abhängigkeit von der mit dem Quantisierer (3) erfaßten Leistung unterhalb einer Leistungsschwelle die Ausgangsimpulse des Quantisierers (3) sperrt, eines Frequenzteilers (4) und einer Anzeige (5), **dadurch gekennzeichnet**, daß dem Quantisierer (3) eine Impulsabstandskontrolle (7) nachgeschaltet ist, die ein Sperrsignal an die Sperre (6) gibt, wenn der zeitliche Abstand zwischen einem ersten und einem nachfolgenden zweiten Impuls eine Zeitschwelle überschreitet, während ansonsten die Sperre (6) unwirksam ist.

2. Statischer Zähler nach Anspruch 1, **dadurch gezeichnet**, daß die Zeitschwelle variabel eingestellt werden kann.

0 268 796

86 P 3394

FIG 1

FIG 2